# EUROPEAN PATENT APPLICATION

(11) **EP 0 582 084 A2**
(43) Date of publication of application: **09.02.1994**
(21) Application number: 93110503.5
(22) Date of filing: 01.07.1993
(51) Int. Cl.: H01L 23/495

(54) **Semiconductor leadframe and package**

(30) Priority: 06.08.1992 US 925143
(71) Applicant: MOTOROLA, INC., Schaumburg, IL 60196 (US)
(72) Inventor: Bailey, Keith W., Mesa. Arizona 85213 (US)
(74) Representative: Spaulding, Sarah Jane

(57) **Abstract**

A semiconductor package (10) comprises a leadframe (14,30) having a plurality of leads (24,26) and a die attach area (20,32) including at least one protrusion (34). A semiconductor die (16) is physically attached to the die attach area (20,32) on the at least one protrusion (34). The die (16) is further coupled to the leads (24,26). An encapsulation (12) is disposed about the semiconductor die (16) and portions of the leadframe (14,30). The protrusions (34) on the die attach area (20,32) enable a uniform layer of die attach material (28) to bond the semiconductor die (16) to the die attach area (20,32) of the leadframe (14,30).

## Description

### Field of the Invention

This invention relates, in general, to the semiconductor arts and more particularly to a semiconductor leadframe and package including the leadframe.

### Background of the Invention

Semiconductor leadframes are used extensively within semiconductor packages. A typical leadframe will include a plurality of leads and a flag including a die attach area. A semiconductor die is bonded to the die attach area and the die is electrically coupled to the leads. The flag and semiconductor die are then encapsulated in plastic or a similar material to form a package.

The flag of a typical leadframe includes a flat planar surface. One method of attaching a semiconductor die to such a flag includes dispensing solder onto a heated leadframe. The heated leadframe melts the solder which flows on the flag. A semiconductor die is then pressed into the molten solder which subsequently solidifies thereby bonding the semiconductor die to the flag.

Although the above method of die attach is widely used, there are various problems associated with its use. For example, when solder is disposed on a heated leadframe, its flow is dfficult to control and there is a tendency for the solder to drift or not be consistently centered on the flag. When the die is subsequently placed, it may not be centered over the molten solder due to the drift. Following compression of the die into the solder, the surface tension of the drifted solder may cause the solder to flow back beneath the die causing it to attach unevenly to the flag. If the die becomes tilted wherein the solder is too thin or too thick beneath portions of the semiconductor die, many problems are caused. If insufficient solder is disposed beneath a portion of the semiconductor die, extreme thermal stress will act on the die and often cause die cracking. If solder beneath a die is too thick, there will be undesired thermal resistance.

Another problem associated with well known die attach methods is that solder is often splashed when the die is pressed therein. Solder often splashes into mold locks disposed on the leadframe adjacent to the flag. If solder lands in these mold locks, the leadframe does not adhere well to the plastic encapsulation with which the package is molded and sealing and hermeticity problems are prevalent. A further problem is that when the semiconductor die is pressed into the molten solder, the solder flows out from beneath the semiconductor die and off the flag. This again causes problems when the solder flows into the mold locks.

Accordingly, it would be highly desirable to have a die attach scheme that would prevent excess solder flow or solder splashing while simultaneously enabling a semiconductor die to be attached to a flag with a uniform layer of die attach therebeneath to reduce stresses acting on the semiconductor die.

### Summary of the Invention

A semiconductor package comprises a leadframe having a plurality of leads and a die attach area wherein the die attach area includes at least one protrusion. A semiconductor die is physically attached to the die attach area on the at least one protrusion. The semiconductor die is also electrically coupled to the leads. An encapsulation is disposed about the semiconductor die and portions of the leadframe.

### Brief Description of the Drawings

FIG. 1 is a highly enlarged isometric view of a semiconductor package; and
FIG. 2 is a highly enlarged isometric view of a portion of a leadframe.

### Detailed Description of the Drawings

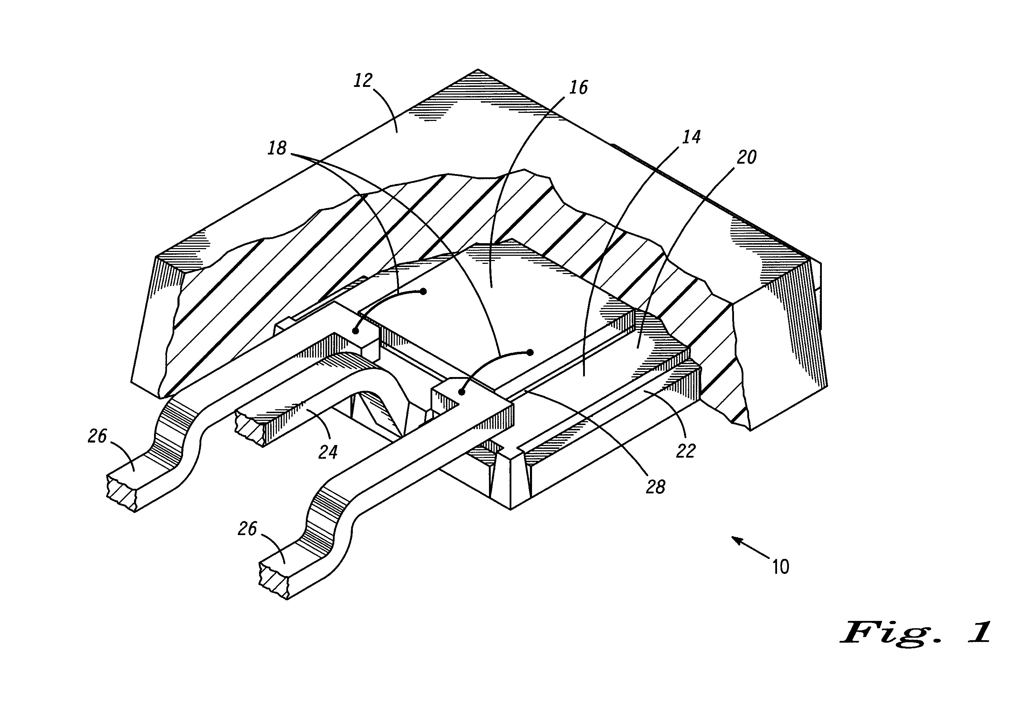

FIG. 1 is a highly enlarged isometric view of a semiconductor package 10. Package 10 as shown is a surface mount package Package 10 includes an encapsulation 12. Encapsulation 12 is shown in outline only so that the internal portions of package 10 may be shown. Encapsulation 12 encapsulates a portion of a leadframe 14, a semiconductor die 16, and wire bonds 18. Encapsulation 12 comprises a molding compound which may be a plastic, epoxy, or other engineering material.

Leadframe 14 comprises a flag 20 including a die attach area on which semiconductor die 16 is mounted. Mold locks 22 are disposed adjacent to flag 20. Mold locks 22 are grooves which serve to enhance sealing and adhesion between leadframe 14 and encapsulation 12.

Semiconductor die 16 is bonded to flag 20 of leadframe 14 with a die attach material 28. Many types of die attach materials 28 are well known in the art. A preferred die attach material would comprise a solder which is both thermally and electrically conductive. By being electrically conductive, solder die attach material 28 would allow electrical coupling from the backside of semiconductor die 16 through flag 20 and externally through a central lead 24. By being thermally conductive, solder die attach material 28 allows heat to be dissipated from semiconductor die 16 through die attach material 28 and into flag 20 so that it may be dissipated outside package 10.

It is necessary that die attach material 28 be of a preferred and uniform thickness between semiconductor die 16 and flag 20 so that semiconductor die 16 is evenly mounted. If semiconductor die 16 is not evenly mounted on flag 20, significantly increased stresses act on die 16 and thermal characteristics are detrimentally effected.

A central lead 24 extends from flag 20 and exits encapsulation 12. Central lead 24 is electrically coupled, through flag 20, to a contact on the backside of semiconductor die 16. Using a typical bipolar transistor as exemplary, lead 24 would be electrically coupled to the collector region of semiconductor die 16 although it is possible that central lead 24 could be coupled to other regions through a backside contact depending upon the configuration of die 16. Although a bipolar transistor is described, it should be understood that other types of devices may be employed with the present invention.

Outer leads 26 also extend from encapsulation 12. Outer leads 26 are not physically or electrically coupled to flag 20. Leads 26 are electrically coupled to semiconductor die 16 by wire bonds 18. Wire bonds 18 typically would have one end coupled to a bond pad or the like on the surface of semiconductor die 16 and another end coupled to outer leads 26. Again, in a typical bipolar transistor, outer leads 26 would typically be coupled to the emitter and base regions of semiconductor die 16. The electrical configuration of package 10 is well known in the art.

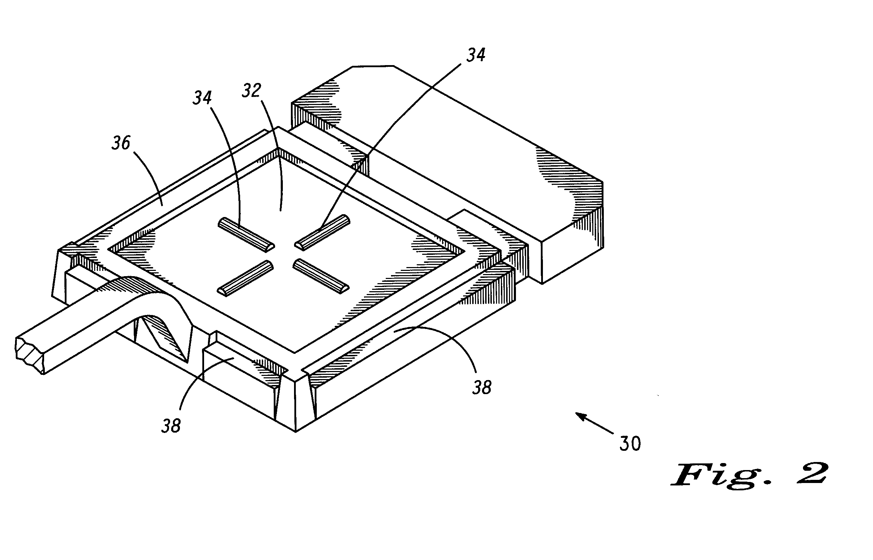

FIG. 2 is a highly enlarged isometric view of a portion of a leadframe 30 for use in a semiconductor package such as package 10 of FIG. 1. Leadframe 30 includes a die attach area 32. Die attach area 32 comprises protrusions 34. Protrusions 34 may be coined or formed by one of many other methods. Protrusions 34 should be on the order of less than 100 micrometers and most preferably should protrude on the order of 25 to 50 micrometers. If a highly thermally conductive die attach material is employed, the height of protrusions 24 may be greater. The arrangement of protrusions 34 on die attach area 32 may be varied. It is desirable however, that protrusions 34 remain completely beneath a semiconductor die mounted thereon although the present invention may also be employed wherein protrusions 34 extend beyond the edge of a semiconductor die. In other cases it is desireable that protrusions 34 be somewhat removed from the edge of a semiconductor die mounted thereon so that stress is not created at the edge of the semiconductor die.

Protrusions 34 serve as stand-offs on which a semiconductor die is mounted. When die attach material is disposed on die attach area 32, it is in the specific area of protrusions 34. Die attach material may be disposed in die attach area 32 by melting solder or the like onto a heated leadframe. When a semiconductor die is subsequently pressed into the molten die attach material, the material flows along protrusions 34 which create a channel effect beneath the die and cause the die attach material to flow evenly. This enables solder flow to be more easily controlled and enhances wetting of the solder to both die attach area 32 and the attached surface of die 16. Additionally, if the amount of die attach material is reasonably controlled, its flow will not extend a significant distance beyond the edges of the semiconductor die.

Protrusions 34 are substantially the same height so that a semiconductor die mounted thereon will not be tilted or the like. When the die is evenly mounted on protrusions 34, less stress will act thereon. Further, the uniform thickness of a controlled amount of die attach material will allow the mismatch of the coeficients of thermal expansion of the various bonded materials to be better compensated for.

The shape of protrusions 34 may be varied. Protrusions 34 may have a substantially radial surface. Protrusions 34 having a radial surface have minimal contact with the surface area of a die mounted thereon. This creates minimal stress. Protrusions 34 may also have a substantially flat surface. Although a flat surfaced protrusion 34 will contact a greater surface area of a semiconductor die mounted thereon, a semiconductor die will be easier to place on a flat surfaced protrusion 34.

A dam wall 36 is disposed about die attach area 32. Dam wall 36 serves to keep excess die attach material from flowing beyond die attach area 32 and possibly into mold locks 38 which serve to better bond seal leadframe 30 to an encapsulation to be disposed thereabout. Dam wall 36 should have a height on the order of 50 to 200 micrometers. Preferably, dam wall 36 will have a height on the order of 75 to 100 micrometers.

A semiconductor package including a leadframe such as leadframe 30 will have many desirable properties. A semiconductor die mounted on protrusions 34 will be attached so that a uniform layer of die attach material is results therebeneath. The uniform solder layer enables reduced stress acting upon a semiconductor die. This will greatly reduce the propensity of a semiconductor die to crack. Further, protrusions 34 will prevent die attach material from flowing well beyond the edges of a semiconductor die mounted thereon. If the optional dam wall 36 is employed, the flow of excess die attach material into areas where package performance or reliability may be reduced is further prohibited.

## Claims

1. A semiconductor package (10) comprising:
a leadframe (14,30) having a plurality of leads (24,26) and a die attach area (20,32) wherein said die attach area (20,32) includes at least one protrusion (34);
a semiconductor die (16) physically attached to said die attach area (20,32) on said at least one protrusion (34), said die (16) further being electrically coupled to said leads (24,26); and
an encapsulation (12) disposed about said semiconductor die (16) and portions of said leadframe (14,30).

2. The package (10) of claim 1 wherein the leadframe (14,30) further includes a dam wall (36) disposed about the die attach area (20,32).

3. The package (10) of claim 1 wherein the at least one protrusion (34) has a substantially flat surface to which the die (16) is attached.

4. The package (10) of claim 1 wherein the at least one protrusion (34) has a substantially radial surface to which the die (16) is attached.

5. The package (10) of claim 1 wherein the at least one protrusion (34) protrudes on the order of less than 100 micrometers.

6. The package (10) of claim 1 wherein the semiconductor die (16) is mounted on the leadframe (14,30) so that the protrusions (34) remain completely beneath said die (16).

7. A leadframe (14,30) for a semiconductor device comprising:
a flag (20) having a die attach area (32) for a semiconductor die (16) to be attached;
a plurality of leads (24,26), at least one of said leads (24) coupled to said flag (20); and
at least one protrusion (34) protruding from said die attach area (32) of said flag (20).

8. The leadframe (14,30) of claim 7 further including a dam wall (36) disposed about the die attach area (32).

9. The leadframe (14,30) of claim 7 wherein the at least one protrusion (34) is arranged on the die attach area (32) so that it will be completely covered by a die (16) mounted thereon.
